# FASCICULE DE BREVET EUROPEEN

(11) **EP 0 962 938 B1**
(45) Date de publication et mention de la délivrance du brevet: **22.11.2000**
(21) Numéro de dépôt: 99470014.4
(22) Date de dépôt: 26.05.1999
(51) Int. Cl.: G11C 7/00

(54) **Circuit intégré comportant au moins deux mémoires**
Integrierte Schaltung mit mindestens zwei Speichern
Integrated circuit comprising at least two memories

(30) Priorité: 05.06.1998 FR 9807200
(43) Date de publication de la demande: 08.12.1999
(73) Titulaire: STMicroelectronics S.A., 94250 Gentilly (FR)
(72) Inventeur: Moreaux, Christophe, 57000 Metz (FR); Leconte, Bruno, 57000 Metz (FR)
(74) Mandataire: Ballot, Paul Denis Jacques

(56) Documents cités:
- EP-A- 0 337 457
- US-A- 5 323 356
- US-A- 5 396 608
- US-A- 5 737 767

## Description

L'invention concerne un circuit intégré comportant au moins deux mémoires différentes. Plus particulièrement, l'invention se rapporte à des circuits intégrés disposant d'une mémoire configurable selon au moins deux formats de données, couplée à une deuxième mémoire.

Pour les systèmes à microprocesseurs, il est couramment utilisé plusieurs types de mémoires différentes. Par exemple, un micro-ordinateur peut disposer simultanément de mémoires RAM, ROM, EPROM, EEPROM, et Flash. Bien évidemment, ces différents types de mémoires peuvent être de capacités différentes et utiliser différents formats de données, en correspondance avec la fonction de chaque mémoire. Ainsi on peut, par exemple, avoir une mémoire Flash d'une capacité de 8 Mbits dont les données sont organisées en 8 bits tout en ayant simultanément une mémoire EEPROM de 256 kbits dont les données sont organisées en 8 bits, dans un système donné. Un autre système peut, par contre, avoir besoin d'une mémoire Flash d'une capacité de 8 Mbits dont les données sont organisées en 16 bits tout en ayant besoin simultanément d'une mémoire EEPROM de 256 kbits dont les données sont organisées en 8 bits.

L'intégration maximale de circuits à l'intérieur d'une puce permet de fiabiliser les systèmes électroniques et tend à diminuer leurs coûts. Si l'on désire intégrer sur une même puce de silicium les deux mémoires, un fabricant de silicium peut facilement construire deux circuits intégrés différents, l'un comprenant une mémoire Flash organisée en 8 bits, et l'autre comprenant une mémoire Flash organisée en 16 bits. Pour le fabricant de semi-conducteurs, il est préférable de fabriquer un unique circuit pouvant être utilisé à la place de ces deux circuits et ce, afin de réduire les coûts et les délais de fabrication.

S'il est connu de réaliser des mémoires à accès parallèle configurables suivant au moins deux formats de données différents, il se pose un problème lorsque l'on couple dans un même circuit une mémoire configurable avec au moins une autre mémoire non configurable ou configurable de manière indépendante. En effet, les deux mémoires sont accessibles à l'aide d'un même bus d'adresse. Or, pour une mémoire configurable, le bus d'adresse est de taille variable suivant la configuration du format des données, et, classiquement, le bit d'adresse rajouté correspond à un bit de poids le plus faible. De plus, si les mémoires utilisées disposent d'accès (en lecture ou en écriture) par page, il est nécessaire que tous les bits d'adresse qui adressent des mots différents dans une même page soient regroupés en bits de poids les plus faibles. De ces contraintes, il résulte qu'il n'est pas possible de coupler une mémoire configurable selon deux formats de données avec une deuxième mémoire qui disposerait d'un accès par page et/ou qui serait également configurable.

L'invention propose de résoudre le problème de l'intégration d'au moins deux mémoires dans un circuit intégré en ayant au moins une des mémoires qui soit configurable selon deux formats de données. Pour réaliser le couplage des deux mémoires, l'invention ajoute au moins un circuit d'aiguillage servant à rediriger deux, ou deux parmi quatre, fils d'adresse dans le circuit intégré pour adresser au moins une des mémoires en fonction de la configuration de la au moins une mémoire configurable.

L'invention a pour objet un circuit intégré comportant au moins une première mémoire configurable selon des premier et deuxième formats de données, une première entrée de sélection de format pour déterminer le format de donnée de la première mémoire, et un bus d'adresse externe pour fournir une adresse au circuit intégré, caractérisé en ce qu'il comporte une deuxième mémoire et un premier bus interne connecté au bus d'adresse externe par un premier circuit de redirection, le premier circuit de redirection effectuant soit une connexion directe du bus d'adresse avec le premier bus interne, soit une connexion entre le bus d'adresse et le premier bus interne en redirigeant deux fils du bus d'adresse externe sur des poids différents suivant qu'un signal présent sur la première entrée de sélection indique que la première mémoire fonctionne avec le premier ou avec le deuxième format, le premier bus interne étant connecté à une entrée d'adresse de l'une des deux mémoires.

L'invention sera mieux comprise et d'autres particularités et avantages apparaîtront à la lecture de la description qui va suivre, la description faisant référence aux dessins annexés parmi lesquels:
les figures 1 à 4 représentent quatre modes de réalisation préférés d'un circuit intégré incorporant deux mémoires selon l'invention,
les figures 5 à 7 représentent trois modes de réalisation préférés d'un circuit de redirection selon l'invention.

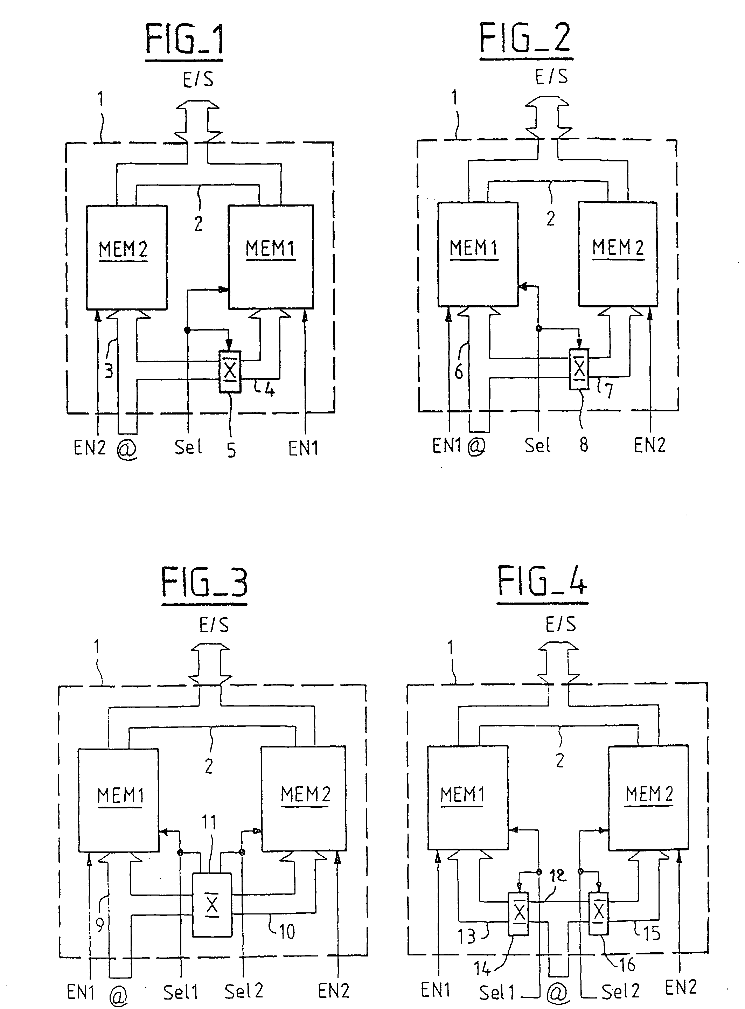

Les figures 1 à 4 représentent de manière simplifiée un circuit intégré 1 comportant une première mémoire MEM1 et une deuxième mémoire MEM2. Il va de soi que l'homme du métier peut transposer l'invention avec un nombre de mémoires supérieur à deux. Chacune des mémoires MEM1 et MEM2 dispose d'une entrée parallèle d'adresse, d'une entrée/sortie parallèle de données et d'une entrée de validation. Bien évidement, d'autres entrées dédiées à divers signaux de contrôle et de commande peuvent être utilisées mais n'ont pas été représentées pour ne pas surcharger les figures.

Le circuit intégré 1 comporte un bus de données 2 connecté d'une part à une entrée/sortie de données E/S du circuit intégré 1 et d'autre part aux entrées/sorties de données des première et deuxième mémoires MEM1 et MEM2. Le circuit intégré 1 dispose également d'une entrée d'adresse @ de type parallèle pour recevoir de l'extérieur une adresse à destination des première et deuxième mémoires MEM1 et MEM2. Deux entrées de validation EN1 et EN2 du circuit intégré 1 sont respectivement connectées aux entrées de validation des première et deuxième mémoires MEM1 et MEM2.

Les figures 1 et 2 correspondent à un circuit intégré 1 dans lequel la première mémoire MEM1 est configurable et la deuxième mémoire MEM2 utilise un format de données fixe. La première mémoire MEM1 dispose d'une entrée de sélection destinée à recevoir un signal de sélection Sel.

Sur le circuit de la figure 1, on considère que la première mémoire MEM1 dispose d'une taille (en terme de capacité de mémoire) qui n'est pas supérieure à la taille de la deuxième mémoire MEM2. Dans ce cas, le circuit intégré 1 dispose d'un bus d'adresse 3, dit externe, qui est connecté entre l'entrée d'adresse de la deuxième mémoire MEM2 et l'entrée d'adresse @ du circuit intégré 1. Il va de soi que l'homme du métier peut ajouter sur ce bus d'adresse des circuits faisant office de tampon d'entrée (amplificateurs, bascules ou autres) du circuit intégré 1. L'entrée d'adresse de la première mémoire MEM1 est connectée à un bus interne 4. Le bus interne 4 est connecté au bus d'adresse externe 3 par l'intermédiaire d'un circuit de redirection 5. Le circuit de redirection 5 comporte une entrée parallèle, une sortie parallèle et une entrée de sélection, l'entrée de sélection recevant le signal de sélection Sel.

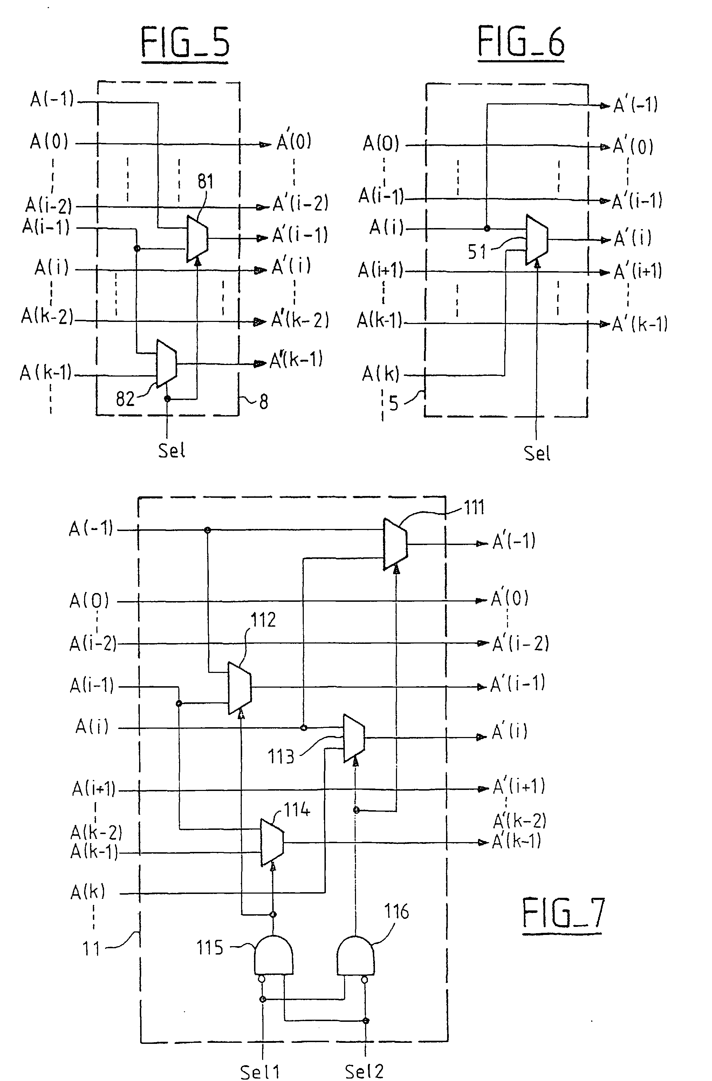

Pour plus de détails sur le circuit de redirection 5, on peut se reporter à la figure 6. La première mémoire MEM1 étant par exemple configurable en 8 bits ou en 16 bits, celle-ci a besoin de k fils d'adresses ou de k + 1 fils d'adresse pour son adressage suivant le format. Par ailleurs, une page de la première mémoire MEM1 correspond à i ou i + 1 fils d'adresse suivant le format de données. Ainsi, l'entrée parallèle du circuit de redirection 5 comporte k + 1 entrées notées A(0) à A(k), et la sortie parallèle du circuit de redirection 5 comporte k + 1 sorties notées A'(-1) à A'(k-1). Les k + 1 entrées A(0) à A(k) correspondent aux bits d'adresse de poids faible de l'adresse fournie au circuit intégré et à la deuxième mémoire MEM2. La sortie A'(-1) correspond au bit de poids le plus faible rajouté lorsque la première mémoire fonctionne en format 8 bits.

Le circuit de redirection 5 comporte un multiplexeur 51 disposant de première et deuxième entrées et d'une sortie. La première entrée du multiplexeur 51 est connectée à l'entrée A(i). La deuxième entrée du multiplexeur 51 est connectée à l'entrée A(k). La sortie du multiplexeur 51 est connectée à la sortie A'(i). Les entrées A(0) à A(i-1) et A(i+1) à A(k-1) sont respectivement connectées aux sorties A'(0) à A'(i-1) et A'(i+1) à A'(k-1). La sortie A'(-1) est connectée à l'entrée A(i).

Lorsque la première mémoire MEM1 fonctionne en format 16 bits, le bit d'adresse de poids -1 est ignoré et peut prendre n'importe quelle valeur. Par ailleurs, le signal de sélection Sel positionne le multiplexeur 51 pour établir une connexion entre l'entrée A(i) et la sortie A'(i). L'adresse fournie à la première mémoire MEM1 est alors la même que l'adresse fournie à la deuxième mémoire MEM2, la connexion entre le bus d'adresse externe 3 et le bus interne 4 s'effectuant de manière directe.

Par contre, lorsque la première mémoire MEM1 fonctionne en format 8 bits, le bit d'adresse de poids -1 est pris en compte comme bit d'adresse de poids le plus faible. Le signal de sélection Sel positionne le multiplexeur 51 pour établir une connexion entre l'entrée A(k) et la sortie A'(i). La connexion entre le bus d'adresse externe 3 et le bus interne 4 s'effectue avec une redirection des fils de poids i et k du bus d'adresse externe 3 sur les fils de poids -1 et i du bus interne 4. Il est à noter que bien que le bit "rajouté" sur le bus d'adresse externe 3 soit un bit qui corresponde au poids le plus fort, les sorties A'(-1) à A'(i-1) correspondant à l'adressage de la page de la première mémoire MEM1 correspondent globalement aux entrées A(0) à A(i) correspondant aux fils de poids faible du bus d'adresse externe 3.

Sur le circuit de la figure 2, on considère que la première mémoire MEM1 dispose d'une taille (en terme de capacité de mémoire) supérieure à la taille de la deuxième mémoire MEM2. Dans ce cas, le circuit intégré 1 dispose d'un bus d'adresse 6, dit externe, qui est connecté entre l'entrée d'adresse de la première mémoire MEM1 et l'entrée d'adresse @ du circuit intégré 1. L'entrée d'adresse de la deuxième mémoire MEM2 est connectée à un bus interne 7. Le bus interne 7 est connecté au bus d'adresse externe 6 par l'intermédiaire d'un circuit de redirection 8. Le circuit de redirection 8 comporte une entrée parallèle, une sortie parallèle et une entrée de sélection, l'entrée de sélection recevant le signal de sélection Sel.

Pour plus de détails sur le circuit de redirection 8 on peut se reporter à la figure 5. La première mémoire MEM1 étant par exemple configurable en 3 bits ou en 16 bits, celle-ci a besoin d'un fil d'adresse de poids faible supplémentaire A(-1) pour être aàressée en mode 3 bits. Par ailleurs, une page de la deuxième mémoire MEM2 correspond à i fils d'adresse de poids faible sur un total de k fils d'adresse. Ainsi, l'entrée parallèle du circuit de redirection 8 comporte k + 1 entrées notées A(-1) à A(k-1). La sortie parallèle du circuit de redirection 8 comporte k sorties notées A'(0) à A'(k-1). Les k + 1 entrées A(-1) à A(k-1) correspondent aux bits d'adresse de poids faible de l'adresse fournie au circuit intégré et à la première mémoire MEM1.

Le circuit de redirection 8 comporte des premier et deuxième multiplexeurs 81 et 82 disposant chacun de première et deuxième entrées et d'une sortie. La première entrée du premier multiplexeur 81 est connectée à l'entrée A(-1). La deuxième entrée du premier multiplexeur 81 est connectée à l'entrée A(i-1). La sortie du premier multiplexeur 81 est connectée à la sortie A'(i-1). La première entrée du deuxième multiplexeur 82 est connectée à l'entrée A(i-1). La deuxième entrée du deuxième multiplexeur 82 est connectée à l'entrée A(k-1). La sortie du deuxième multiplexeur 82 est connectée à la sortie A'(k-1). Les entrées A(0) à A(i-2) et A(i) à A(k-2) sont respectivement connectées aux sorties A'(0) à A'(i-2) et A'(i) à A'(k-2).

Lorsque la première mémoire MEM1 fonctionne en format 16 bits, le bit d'adresse de poids -1 est inutilisé et donc normalement non connecté. Le signal de sélection Sel positionne le premier multiplexeur 81 pour établir une connexion entre l'entrée A(i-1) et la sortie A'(i-1). Le signal de sélection Sel positionne également le deuxième multiplexeur 82 pour établir une connexion entre l'entrée A(k-1) et la sortie A'(k-1). L'adresse fournie à la première mémoire MEM1 est alors la même que l'adresse fournie à la deuxième mémoire MEM2, la connexion entre le bus d'adresse externe 6 et le bus interne 7 s'effectuant de manière directe.

Par contre, lorsque la première mémoire MEM1 fonctionne en format 8 bits, le bit d'adresse de poids -1 est pris en compte comme bit d'adresse de poids le plus faible et se trouve alors utilisé. Le signal de sélection Sel positionne le premier multiplexeur 81 pour établir une connexion entre l'entrée A(-1) et la sortie A'(i-1). Le signal de sélection Sel positionne également le deuxième multiplexeur 82 pour établir une connexion entre l'entrée A(i-1) et la sortie A'(k-1). La connexion entre le bus d'adresse externe 6 et le bus interne 7 s'effectue avec une redirection des fils de poids -1 et i-1 du bus d'adresse externe 6 sur les fils de poids i-1 et k-1 du bus interne 7. Il est à noter que le bit "rajouté" sur le bus d'adresse externe 6 est déplacé pour être le bit de poids le plus fort d'une adresse de la page de la deuxième mémoire MEM2 afin que l'adressage de la page de la deuxième mémoire MEM2 corresponde globalement aux entrées A(-1) à A(i-1) correspondant aux fils de poids faible du bus d'adresse externe.

Pour les exemples précédemment décrits, on a utilisé une correspondance directe entre les adresses de poids identiques. Il est tout à fait possible de réaliser une correspondance directe décalée. Ce qui reviendrait à avoir, pour la figure 6, les entrées A(0) à A(k) reliées directement et respectivement aux sorties A'(-1) à A'(k-1) ainsi que la redirection des entrées A(0) et A(i) respectivement sur les sorties A'(i-1) et A'(k-1). Pour la figure 5, cela reviendrait à avoir, les entrées A(-1) à A(k-2) reliées directement et respectivement aux sorties A'(0) à A'(k-1) ainsi que la redirection des entrées A(i-1) et A(k-2) respectivement sur les sorties A'(0) et A'(i).

D'une manière plus générale, cela revient, dans un cas, à ce que le circuit de redirection redirige le fil d'adresse de poids le plus faible du bus d'adresse externe (lorsque ce fil doit être redirigé) sur un fil de poids intermédiaire du bus interne et redirige le fil d'adresse correspondant au poids intermédiaire du bus d'adresse externe sur le fil de poids le plus fort du bus interne. Afin d'effectuer un minimum de redirections, le fil de poids intermédiaire correspond au fil d'adresse de poids le plus fort pouvant adresser une page de la mémoire qui est connectée au bus interne.

Egalement, dans un autre cas, le circuit de redirection redirige le fil d'adresse de poids fort du bus d'adresse externe (lorsque ce fil doit être redirigé) sur un fil de poids défini du bus interne et redirige le fil d'adresse correspondant au poids défini du bus d'adresse externe sur le fil de poids le plus faible du bus interne. Afin d'effectuer un minimum de redirections, le fil du poids défini correspond au fil d'adresse de poids immédiatement supérieur au fil d'adresse de poids le plus fort pouvant adresser une page de la mémoire connectée au bus interne. Afin que les adresses de la mémoire connectée au bus interne soient successives, il est préférable que le fil de poids fort du bus d'adresse externe corresponde au poids d'adresse immédiatement supérieur au poids le plus fort de la mémoire connectée au bus interne.

Les figures 3 et 4 correspondent à un circuit intégré 1 dans lequel la première mémoire MEM1 est configurable et la deuxième mémoire MEM2 est également configurable. La première mémoire MEM1 dispose d'une entrée de sélection destinée à recevoir un premier signal de sélection de format Sell. La deuxième mémoire MEM2 dispose d'une entrée de sélection destinée à recevoir un deuxième signal de sélection de format Sel2.

Sur le circuit de la figure 3, on considère que la première mémoire MEM1 dispose d'une taille (en terme de capacité de mémoire) supérieure à la taille de la deuxième mémoire MEM2. Dans ce cas, le circuit intégré 1 dispose d'un bus d'adresse 9, dit externe, qui est connecté entre l'entrée d'adresse de la première mémoire MEM1 et l'entrée d'adresse @ du circuit intégré 1. L'entrée d'adresse de la deuxième mémoire MEM2 est connectée à un bus interne 10. Le bus interne 10 est connecté au bus d'adresse externe 9 par l'intermédiaire d'un circuit de redirection 11. Le circuit de redirection 11 comporte une entrée parallèle, une sortie parallèle et des première et deuxième entrées de sélection, les première et deuxième entrées de sélection recevant respectivement les premier et deuxième signaux de sélection Sel1 et Sel2.

Pour plus de détails sur le circuit de redirection 11, on peut se reporter à la figure 7. Les première et deuxième mémoires MEM1 et MEM2 étant, par exemple, configurables en 8 bits ou en 16 bits, celles-ci ont besoin d'un fil d'adresse de poids faible supplémentaire A(-1) et A'(-1) pour être adressées en mode 8 bits. Par ailleurs, une page de la deuxième mémoire MEM2 correspond à i ou i + 1 fils d'adresse de poids faible sur un total de k ou k + 1 fils d'adresse. Ainsi, l'entrée parallèle du circuit de redirection 11 comporte k + 2 entrées notées A(-1) à A(k), et la sortie parallèle du circuit de redirection 11 comporte k + 1 sorties notées A'(-1) à A'(k-1). Les k + 2 entrées A(-1) à A(k) correspondent aux bits d'adresse de poids faible de l'adresse fournie au circuit intégré 1 et à la première mémoire MEM1.

Le circuit de redirection 11 comporte des premier à quatrième multiplexeurs 111 à 114, disposant chacun de première et deuxième entrées et d'une sortie, et des première et deuxième porte de décodage 115 et 116. La première entrée du premier multiplexeur 111 est connectée à l'entrée A(-1). La deuxième encrée du premier multiplexeur 111 est connectée à l'entrée A(i). La sortie du premier multiplexeur 111 est connectée à la sortie A'(-1). La première entrée du deuxième multiplexeur 112 est connectée à l'entrée A(-1). La deuxième entrée du deuxième multiplexeur 112 est connectée à l'entrée A(i-1). La sortie du deuxième multiplexeur 112 est connectée à la sortie A'(i-1). La première entrée du troisième multiplexeur 113 est connectée à l'entrée A(i). La deuxième entrée du troisième multiplexeur 113 est connectée à l'entrée A'(k). La sortie du troisième multiplexeur 113 est connectée à la sortie A'(i). La première entrée du quatrième multiplexeur 114 est connectée à l'entrée A(i-1). La deuxième entrée du quatrième multiplexeur 114 est connectée à l'entrée A(k-1). La sortie du quatrième multiplexeur 114 est connectée à la sortie A'(k-1). Les entrées A(0) à A(i-2) et A(i+1) à A(k-2) sont respectivement connectées aux sorties A'(0) à A'(i-2) et A'(i+1) à A'(k-2).

Les première et deuxième portes 115 et 116 reçoivent chacune les premier et deuxième signaux de sélection Sel1 et Sel2. La première porte 115 fournit un signal de commande pour les deuxième et quatrième multiplexeurs 112 et 114. La deuxième porte 116 fournit un signal de commande pour les premier et troisième multiplexeurs 111 et 113. Les première et deuxième portes servent à sélectionner les différentes combinaisons de connexion en fonction des signaux de sélection Sel1 et Sel2.

Lorsque les première et deuxième mémoires MEM1 et MEM2 fonctionnent avec un même format, les signaux de sélection Sel1 et Sel2 positionnent par l'intermédiaire des portes 115 et 116 le premier multiplexeur 111 pour établir une connexion entre l'entrée A(-1) et la sortie A'(-1), le deuxième multiplexeur 112 pour établir une connexion entre l'entrée A(i-1) et la sortie A'(i-1), le troisième multiplexeur 113 pour établir une connexion entre l'entrée A(i) et la sortie A'(i), le quatrième multiplexeur 114 pour établir une connexion entre Ventrée A(k-1) et la sortie A'(k-1). L'adresse fournie à la première mémoire MEM1 est alors la même que l'adresse fournie à la deuxième mémoire MEM2. La connexion entre le bus d'adresse externe 9 et le bus interne 10 s'effectuent de manière directe. On remarque que lorsque les première et deuxième mémoires MEM1 et MEM2 sont positionnées pour fonctionner toutes les deux en 16 bits, la connexion établie entre A(-1) et A'(-1) est inutile mais réalisée pour des raisons de simplification de structure.

Lorsque la première mémoire MEM1 est configurée pour fonctionner en 16 bits et que la deuxième mémoire MEM2 est configurée pour fonctionner en 8 bits, les signaux de sélection Sell et Sel2 positionnent par l'intermédiaire des portes 115 et 116 le premier multiplexeur 111 pour établir une connexion entre l'entrée A(i) et la sortie A'(-1), le deuxième multiplexeur 112 pour établir une connexion entre l'entrée A(i-1) et la sortie A'(i-1), le troisième multiplexeur 113 pour établir une connexion entre l'entrée A(k) et la sortie A'(i), le quatrième multiplexeur 114 pour établir une connexion entre l'entrée A(k-1) et la sortie A'(k-1). La connexion entre le bus d'adresse externe 9 et le bus interne 10 s'effectue avec une redirection des fils de poids i et k du bus d'adresse externe sur les fils de poids -1 et i du bus interne. Il est à noter que ce fonctionnement est analogue à la redirection d'adresse effectuée par le circuit de redirection 5 de la figure 6.

Lorsque la première mémoire MEM1 est configurée pour fonctionner en 8 bits et que la deuxième mémoire MEM2 est configurée pour fonctionner en 16 bits, les signaux de sélection Sell et Sel2 positionnent par l'intermédiaire des portes 115 et 116 le premier multiplexeur 111 pour établir une connexion entre l'entrée A(-1) et la sortie A'(-1), le deuxième multiplexeur 112 pour établir une connexion entre l'entrée A(-1) et la sortie A'(i-1), le troisième multiplexeur 113 pour établir une connexion entre l'entrée A(i) et la sortie A'(i), le quatrième multiplexeur i14 pour établir une connexion entre l'entrée A(i-1) et la sortie A'(k-1). La connexion entre le bus d'adresse externe 9 et le bus interne 10 s'effectue avec une redirection des fils de poids -1 et i-1 du bus d'adresse externe 9 sur les fils de poids i-1 et k-1 du bus interne 10. Il est à noter que ce fonctionnement est analogue à la redirection d'adresse effectuée par le circuit de redirection 8 de la figure 5.

On remarque que le circuit de redirection 11 réalise soit une connexion directe entre le bus interne et le bus d'adresse externe lorsque les deux mémoires sont configurées avec un même format, soit une connexion entre le bus d'adresse et le premier bus interne en redirigeant deux fils parmi quatre lorsque les deux mémoires sont configurées différemment. Il est à noter que les remarques faites en relation avec les figures 1 et 2 s'appliquent également au schéma de la figure 3.

De plus, pour les schémas des figures 1 à 3, on a toujours connecté la mémoire ayant la plus grande taille au bus d'adresse externe. Bien que ce ne soit pas une nécessité, il est préférable de procéder ainsi afin d'éviter, dans certains cas, d'avoir un plot de connexion supplémentaire sur la puce.

Sur le circuit de la figure 4, on a représenté une manière de réaliser le circuit intégré 1 qui est facilement transposable à un nombre quelconque dé mémoires. Sur cette figure 4, le circuit intégré 1 dispose d'un bus d'adresse 12 dit externe qui est connecté à l'entrée d'adresse @ du circuit intégré 1. L'entrée d'adresse de la première mémoire MEM1 est connectée à un premier bus interne 13. Le premier bus interne 13 est connecté au bus d'adresse externe 12 par l'intermédiaire d'un premier circuit de redirection 14. L'entrée d'adresse de la deuxième mémoire MEM2 est connectée à un deuxième bus interne 15. Le deuxième bus interne 15 est connecté au bus d'adresse externe 12 par l'intermédiaire d'un deuxième circuit de redirection 16. Chacun des circuits de redirection 14 et 16 comporte une entrée parallèle, une sortie parallèle et une entrée de sélection. Les entrées de sélection des premier et deuxième circuits de redirection reçoivent respectivement les premier et deuxième signaux de sélection Sel1 et Sel2.

Pour ce qui est des premier et deuxième circuits de redirection 14 et 16, ils sont constitués de manière identique ou équivalente au circuit de redirection 5 de la figure 6. Toutefois, les entrées A(0) à A(k) de cette figure 6 sont à considérer uniquement comme l'entrée d'adresse vue par l'extérieur du circuit.

Ainsi, le premier circuit de redirection 14 effectue soit une connexion directe du bus d'adresse externe 12 avec le premier bus interne 13, soit une connexion redirigée entre le bus d'adresse externe 12 et le premier bus interne 13 en redirigeant deux fils du bus d'adresse externe 12 sur des poids différents en fonction du premier signal Sel1 qui indique que la première mémoire MEM1 fonctionne en format 8 ou 16 bits. Le deuxième circuit de redirection 16 effectue soit une connexion directe du bus d'adresse externe 12 avec le deuxième bus interne 15, soit une connexion redirigée entre le bus d'adresse externe 12 et le deuxième bus interne 15 en redirigeant deux fils du bus d'adresse externe 12 sur des poids différents en fonction du deuxième signal Sel2 qui indique que la deuxième mémoire MEM2 fonctionne en format 8 ou 16 bits.

Le circuit intégré 1 comprend, pour le mode de réalisation de la figure 4 deux mémoire fonctionnant de manière indépendante l'une de l'autre. L'ajout d'une troisième mémoire sur le schéma de la figure 4 demande l'ajout d'un troisième bus interne et d'un troisième circuit de redirection. La mise en oeuvre de la troisième mémoire est à calquer sur la mise en oeuvre de la première ou deuxième mémoire.

De nombreuses variantes sont à la disposition de l'homme du métier sans sortir du cadre de l'invention. En plus des variations possibles qui ont déjà été citées, il est à noter que toutes les informations numériques données à titre d'exemple peuvent être modifiées suivant les besoins de l'homme du métier.

## Revendications

1. Circuit intégré (1) comportant au moins une première mémoire (MEM1) configurable selon des premier et deuxième formats de données, une première entrée de sélection de format pour déterminer le format de donnée de la première mémoire (MEM1), et un bus d'adresse externe (3, 6, 9, 12) pour fournir une adresse au circuit intégré (1), caractérisé en ce qu'il comporte une deuxième mémoire (MEM2) et un premier bus interne (4, 7, 10, 13) connecté au bus d'adresse externe (3, 6, 9, 12) par un premier circuit de redirection (5, 8, 11, 14), le premier circuit de redirection (5, 8, 11, 14) effectuant soit une connexion directe du bus d'adresse externe (3, 6, 9, 12) avec le premier bus interne (4, 7, 10, 13), soit une connexion entre le bus d'adresse externe (3, 6, 9, 12) et le premier bus interne (4, 7, 10, 13) en redirigeant deux fils du bus d'adresse externe (3, 6, 9, 12) sur des poids différents, suivant qu'un premier signal (Sel, Sel1) présent sur la première entrée de sélection indique que la première mémoire (MEM1) fonctionne avec le premier ou avec le deuxième format, le premier bus interne (4, 7, 10, 13) étant connecté à une entrée d'adresse de l'une des deux mémoires (MEM1 ou MEM2).

2. Circuit selon la revendication 1, caractérisé en ce que le circuit de redirection (8, 11) redirige le il d'adresse de poids le plus faible (A(-1)) du bus d'adresse externe (6, 9) sur un fil de poids intermédiaire (A'(i-1)) du premier bus interne (7, 10), et redirige un fil d'adresse de poids intermédiaire (A(i-1)) du bus d'adresse externe (6, 9) sur un fil de poids le plus fort (A(k-1)) du premier bus interne (7, 10).

3. Circuit selon la revendication 2, caractérisé en ce que le fil de poids intermédiaire (A'(i-1)) correspond au fil d'adresse de poids le plus fort pouvant adresser une page de la mémoire qui est connectée au premier bus interne.

4. Circuit selon l'une des revendications 1 à 3, caractérisé en ce que le circuit de redirection (5, 11, 14) redirige le fil d'adresse de poids fort (A(k)) du bus d'adresse externe (3, 9, 12) sur un fil de poids défini (A'(i)) du premier bus interne (4, 10, 13) et redirige un fil d'adresse de poids défini (A(i)) du bus d'adresse externe (3, 9, 12) sur un fil de poids le plus faible (A'(-1)) du premier bus interne (4, 10, 13).

5. Circuit selon la revendication 4, caractérisé en ce que le fil de poids défini (A'(i)) correspond au fil d'adresse de poids immédiatement supérieur au fil d'adresse de poids le plus fort pouvant adresser une page de la mémoire connectée au premier bus interne.

6. Circuit selon l'une des revendications 4 ou 5, caractérisé en ce que le fil de poids fort (A(k)) du bus d'adresse correspond au poids d'adresse immédiatement supérieur au poids le plus fort de la mémoire connectée au premier bus interne.

7. Circuit selon l'une des revendications 1 à 6, caractérisé en ce que la deuxième mémoire (MEM2) est configurable selon les premier et deuxième formats de données, et en ce que le circuit comporte une deuxième entrée de sélection de format pour recevoir un deuxième signal (Sel2) qui détermine le format de donnée de la deuxième mémoire.

8. Circuit selon la revendication 7, caractérisé en ce que le premier circuit de redirection (11) réalise soit une connexion directe entre le premier bus interne (10) et le bus d'adresse externe (9) lorsque les deux mémoires (MEM1 et MEM2) sont configurées avec un même format, soit une connexion entre le bus d'adresse externe (9) et le premier bus interne (10) en redirigeant deux fils parmi quatre lorsque les deux mémoires (MEM1 et MEM2) sont configurées différemment.

9. Circuit selon la revendication 7, caractérisé en ce qu'il comporte un deuxième bus interne (15) connecté au bus d'adresse externe (12) par un deuxième circuit de redirection (16), le deuxième circuit de redirection (16) effectuant soit une connexion directe du bus d'adresse externe (12) avec le deuxième bus interne (15), soit une connexion entre le bus d'adresse externe (12) et le deuxième bus interne (15) en redirigeant deux fils du bus d'adresse externe (12) sur des poids différents en fonction du deuxième signal (Sel2) présent sur la deuxième entrée de sélection, suivant que la deuxième mémoire (MEM2) fonctionne dans le premier ou deuxième format, le deuxième bus interne (15) étant connecté à l'entrée d'adresse de la deuxième mémoire (MEM2), et le premier bus interne (13) étant connecté à l'entrée de la première mémoire (MEM1).

10. Circuit selon l'une des revendications 1 à 8, caractérisé en ce que les première et deuxième mémoires (MEM1 et MEM2) ont respectivement une première et une deuxième tailles, et en ce que:
- si la première taille est supérieure à la deuxième taille alors la première mémoire (MEM1) est connectée au bus d'adresse externe (6, 9) et la deuxième mémoire (MEM2) est connectée au premier bus interne (7, 10), et
- si la première taille n'est pas supérieure à la deuxième taille alors la première mémoire (MEM1) est connectée au premier bus interne (4) et la deuxième mémoire (MEM2) est connectée au bus d'adresse externe (3).

## Patentansprüche

1. Integrierte Schaltung (1) mit mindestens einem gemäß ersten und zweiten Datenformaten konfigurierbaren ersten Speicher (MEM1), einem ersten Formatauswahleingang, um das Format der Daten des ersten Speichers (MEM1) zu bestimmen, und einem externen Adressenbus (3, 6, 9, 12), um eine Adresse an die integrierte Schaltung (1) zu liefern, dadurch gekennzeichnet, daß sie einen zweiten Speicher (MEM2) und einen ersten internen Bus (4, 7, 10, 13) aufweist, der mit dem externen Adressenbus (3, 6, 9, 12) über eine erste Umordnungsschaltung (5, 8, 11, 14) verbunden ist, wobei die erste Umordnungsschaltung (5, 8, 11, 14) entweder eine direkte Verbindung zwischen dem externen Adressenbus (3, 6, 9, 12) und dem ersten internen Bus (4, 7, 10, 13) oder eine solche Verbindung zwischen dem externen Adressenbus (3, 6, 9, 12) und dem ersten internen Bus (4, 7, 10, 13) herstellt, daß zwei Drähte des externen Adressenbusses (3, 6, 9, 12) auf verschiedene Gewichtungen umgeordnet werden, je nachdem, ob ein am ersten Auswahleingang vorliegendes erstes Signal (Sel, Seil) angibt, daß der erste Speicher (MEM1) mit dem ersten oder mit dem zweiten Format arbeitet, wobei der erste interne Bus (4, 7, 10, 13) mit einem Adresseneingang eines der beiden Speicher (MEM1 oder MEM2) verbunden ist.

2. Schaltung nach Anspruch 1, dadurch gekennzeichnet, daß die Umordnungsschaltung (8, 11) den Adressendraht geringster Gewichtung (A(-1)) des externen Adressenbusses (6, 9) auf einen Draht mit Zwischengewichtung (A'(i-1)) des ersten internen Busses (7, 10) umordnet und einen Adressendraht mit Zwischengewichtung (A(i-1)) des externen Adressenbusses (6, 9) auf einen Draht höchster Gewichtung ((A(k-1)) des ersten internen Busses (7, 10) umordnet.

3. Schaltung nach Anspruch 2, dadurch gekennzeichnet, daß der Draht mit Zwischengewichtung (A'(i-1)) dem Draht höchster Gewichtung entspricht, der eine Seite des Speichers adressieren kann, der mit dem ersten internen Bus verbunden ist.

4. Schaltung nach einem der Ansprüche 1 bis 3, dadurch gekennzeichnet, daß die Umordnungsschaltung (5, 11, 14) den Adressendraht hoher Gewichtung (A(k)) des externen Adressenbusses (3, 9, 12) auf einen Draht definierter Gewichtung (A'(i)) des ersten internen Busses (4, 10, 13) umordnet und einen Adressendraht definierter Gewichtung (A(i)) des externen Adressenbusses (3, 9, 12) auf einen Draht geringster Gewichtung (A'(-1)) des internen Busses (4, 10, 13) umordnet.

5. Schaltung nach Anspruch 4, dadurch gekennzeichnet, daß der Draht definierter Gewichtung (A'(i)) dem Adressendraht entspricht, dessen Gewichtung unmittelbar über der des Adressendrahts höchster Gewichtung liegt, der eine Seite des mit dem ersten internen Bus verbundenen Speichers adressieren kann.

6. Schaltung nach einem der Ansprüche 4 oder 5, dadurch gekennzeichnet, daß der Draht hoher Gewichtung (A(k)) des Adressenbusses der Gewichtung des Adressendrahts entspricht, die unmittelbar über der höchsten Gewichtung des mit dem ersten internen Bus verbundenen Speichers liegt.

7. Schaltung nach einem der Ansprüche 1 bis 6, dadurch gekennzeichnet, daß der zweite Speicher (MEM2) gemäß dem ersten und dem zweiten Datenformat konfiguriert werden kann, und daß die Schaltung einen zweiten Formatauswahleingang aufweist, um ein zweites Signal (Se12) zu empfangen, das das Datenformat des zweiten Speichers bestimmt.

8. Schaltung nach Anspruch 7, dadurch gekennzeichnet, daß die erste Umordnungsschaltung (11) entweder eine direkte Verbindung zwischen dem ersten internen Bus (10) und dem externen Adressenbus (9), wenn die beiden Speicher (MEM1 und MEM2) mit dem gleichen Format konfiguriert sind, oder eine Verbindung zwischen dem externen Adressenbus (9) und dem ersten internen Bus (10) herstellt, indem sie zwei von vier Drähten umordnet, wenn die beiden Speicher (MEM1 und MEM2) unterschiedlich konfiguriert sind.

9. Schaltung nach Anspruch 7, dadurch gekennzeichnet, daß sie einen zweiten internen Bus (15) aufweist, der mit dem externen Adressenbus (12) über eine zweite Umordnungsschaltung (16) verbunden ist, wobei die zweite Umordnungsschaltung (16) entweder eine direkte Verbindung zwischen dem externen Adressenbus (12) und dem zweiten internen Bus (15) oder eine solche Verbindung zwischen dem externen Adressenbus (12) und dem zweiten internen Bus (15) herstellt, daß zwei Drähte des externen Adressenbusses (12) in Abhängigkeit vom zweiten, am zweiten Auswahleingang vorhandenen Signal (Sel2) auf unterschiedliche Gewichtungen umgeordnet werden, je nachdem, ob der zweite Speicher (MEM2) im ersten oder im zweiten Format arbeitet, wobei der zweite interne Bus (15) mit dem Adresseneingang des zweiten Speichers (MEM2) und der erste interne Bus (13) mit dem Eingang des ersten Speichers (MEM1) verbunden ist.

10. Schaltung nach einem der Ansprüche 1 bis 8, dadurch gekennzeichnet, daß der erste und der zweite Speicher (MEM1 und MEM2) je eine erste bzw. eine zweite Größe aufweisen, und daß:
- wenn die erste Größe größer ist als die zweite Größe, der erste Speicher (MEM1) mit dem externen Adressenbus (6, 9) und der zweite Speicher (MEM2) mit dem ersten internen Bus (7, 10) verbunden ist, und
- wenn die erste Größe nicht größer ist als die zweite Größe, der erste Speicher (MEM1) mit dem ersten internen Bus (4) und der zweite Speicher (MEM2) mit dem externen Adressenbus (3) verbunden ist.

## Claims

1. Integrated circuit (1) having at least one first memory (MEM1) configurable according to first and second data formats, a first format selection input for determining the data format of the first memory (MEM1), and an external address bus (3, 6, 9, 12) for supplying an address to the integrated circuit (1), characterised in that it has a second memory (MEM2) and a first internal bus (4, 7, 10, 13) connected to the external address bus (3, 6, 9, 12) by a first redirection circuit (5, 8, 11, 14), the first redirection circuit (5, 8, 11, 14) effecting either a direct connection of the external address bus (3, 6, 9, 12) with the first internal bus (4, 7, 12, 13), or a connection between the external address bus (3, 6, 9, 12) and the first internal bus (4, 7, 10, 13) by redirecting two wires of the external address bus (3, 6, 9, 12) onto different significances, depending on whether a first signal (Sel, Sell) present at the first selection input indicates that the first memory (MEM1) is functioning with the first or second format, the first internal bus (4, 7, 10, 13) being connected to an address input of one of the two memories (MEM1 or MEM2).

2. Circuit according to Claim 1, characterised in that the redirection circuit (8, 11) redirects the least significant address wire (A(-1)) of the external address bus (6, 9) onto a wire of intermediate significance (A'(i-1)) of the first internal bus (7, 10), and redirects an address wire of intermediate significance (A(i-1)) of the external address bus (6, 9) onto a wire with the most significance (A(k-1)) of the first internal bus (7, 10).

3. Circuit according to Claim 2, characterised in that the wire of intermediate significance (A'(i-1)) corresponds to the most significant address wire able to address a page of the memory which is connected to the first internal bus.

4. Circuit according to one of Claims 1 to 3, characterised in that the redirection circuit (5, 11, 14) redirects the most significant address wire (A(k)) of the external address bus (3, 9, 12) onto a wire of defined significance (A'(i)) of the first internal bus (4, 10, 13) and redirects an address wire of defined significance (A(i)) of the external address bus (3, 9, 12) onto a least significant wire (A'(-1)) of the first internal bus (4, 10, 13).

5. Circuit according to Claim 4, characterised in that the wire of defined significance (A'(i)) corresponds to the address wire with a significance immediately greater than the most significant address wire able to address a page of the memory connected to the first internal bus.

6. Circuit according to one of Claims 4 or 5, characterised in that the most significant wire (A(k)) of the address bus corresponds to the address significance immediately greater than the greatest significance of the memory connected to the first internal bus.

7. Circuit according to one of Claims 1 to 6, characterised in that the second memory (MEM2) is configurable according to the first and second data formats, and in that the circuit has a second format selection input for receiving a second signal (Sel2) which determines the data format of the second memory.

8. Circuit according to Claim 7, characterised in that the first redirection circuit (11) effects either a direct connection between the first internal bus (10) and the external address bus (9) when the two memories (MEM1 and MEM2) are configured with the same format, or a connection between the external address bus (9) and the first internal bus (10) by redirecting two wires amongst four when the two memories (MEM1 and MEM2) are configured differently.

9. Circuit according to Claim 7, characterised in that it has a second internal bus (15) connected to the external address bus (12) by a second redirection circuit (16), the second redirection circuit (16) effecting either a direct connection of the external address bus (12) with the second internal bus (15), or a connection between the external address bus (12) and the second internal bus (15) by redirecting two wires of the external address bus (12) onto different significances according to the second signal (Sel2) present at the second selection input, depending on whether the second memory (MEM2) is functioning in the first or second format, the second internal bus (15) being connected to the address input of the second memory (MEM2), and the first internal bus (13) being connected to the input of the first memory (MEM1).

10. Circuit according to one of Claims 1 to 8, characterised in that the first and second memories (MEM1 and MEM2) have respectively first and second sizes, and in that:
- if the first size is greater than the second size then the first memory (MEM1) is connected to the external address bus (6, 9) and the second memory (MEM2) is connected to the first internal bus (7, 10), and
- if the first size is not greater than the second size then the first memory (MEM1) is connected to the first internal bus (4) and the second memory (MEM2) is connected to the external address bus (3).
